(19) Europäisches Patentamt
European Patent Office
Office européen des brevets

(11) **EP 1 588 462 B1**

(12) **EUROPÄISCHE PATENTSCHRIFT**

(45) Veröffentlichungstag und Bekanntmachung des Hinweises auf die Patenterteilung:
**15.08.2007 Patentblatt 2007/33**

(21) Anmeldenummer: **04701330.5**

(22) Anmeldetag: **12.01.2004**

(51) Int Cl.:
*H01S 3/10* (2006.01)      *H01S 3/23* (2006.01)

(86) Internationale Anmeldenummer:
**PCT/AT2004/000002**

(87) Internationale Veröffentlichungsnummer:
**WO 2004/064208 (29.07.2004 Gazette 2004/31)**

(54) **POLARISATIONSOPTISCHE KOMBINATION VON GEPULSTEN LASERDIODEN ZUR LEISTUNGSSTEIGERUNG IM LASERBÜNDEL**

POLARISATION OPTICAL COMBINATION OF PULSED LASER DIODES FOR IMPROVING THE PERFORMANCE OF A LASER BEAM

COMBINAISON OPTIQUE DE POLARISATION DE DIODES LASER A IMPULSIONS POUR AUGMENTER LA PUISSANCE D'UN FAISCEAU LASER

(84) Benannte Vertragsstaaten:
**AT BE BG CH CY CZ DE DK EE ES FI FR GB GR HU IE IT LI LU MC NL PT RO SE SI SK TR**

(30) Priorität: **13.01.2003 AT 322003**
**05.09.2003 AT 2202004**

(43) Veröffentlichungstag der Anmeldung:
**26.10.2005 Patentblatt 2005/43**

(73) Patentinhaber: **Austria Wirtschaftsservice GmbH**
**1030 Vienna (AT)**

(72) Erfinder: **BAMMER, Ferdinand**
**A-1040 Vienna (AT)**

(74) Vertreter: **Patentanwälte**
**BARGER, PISO & PARTNER**
**Mahlerstrasse 9**
**P. O. Box 96**
**1015 Wien (AT)**

(56) Entgegenhaltungen:
DE-A- 4 009 859          US-A- 5 250 810
US-A1- 2002 000 426      US-B1- 6 391 022

**Beschreibung**

Die Erfindung betrifft ein Verfahren zur Schaffung eines Laserstrahles hoher Brillanz unter Verwendung von $2^{n+1}$ Laserquellen, wobei n eine ganze, positive Zahl darstellt, bei dem die Laserquellen in gepulstem Modus betrieben werden und die erzeugten Laserpulse in einem optischen Multiplexer auf einen gemeinsamen optischen Pfad gelenkt werden.

Die gängigsten Laser für Materialbearbeitung sind $CO_2$-, NdYag- und Diodenlaser. Typische Anwendungen sind Schneiden, Schweißen, (Hart-)Löten, Härten, Enthärten, Markieren, Gravieren, Beschriften, Beschichten, Reinigen und Bohren von Metallen und Nichtmetallen. Äquivalente Anwendungen finden sich auch in der Medizintechnik, z.B. in der Chirurgie oder in der Dentalmedizin. $CO_2$- und NdYag-Laser verfügen üblicherweise über eine sehr gute Strahlqualität und können daher für Anwendungen, welche eine sehr hohe Intensität ($>10^6 W/cm^2$) im Fokus benötigen, eingesetzt werden. Allerdings haben diese Lasertypen einen relativ schlechten Wirkungsgrad (5 - 20%) und sind komplizierte und aufwendig zu bedienende Geräte. Diodenlaser sind hingegen kompakt, hocheffizient (Wirkungsgrad typischerweise 40-50%, für die Zukunft sind weitere Steigerungen zu erwarten) und einfach zu bedienen, sie haben aber eine sehr schlechte Strahlqualität und sind somit für viele Anwendungen nicht verwendbar.

Zur Beurteilung der Brauchbarkeit von Diodenlasern dient das Konzept der Brillianz. Hierfür benötigt man das Strahlparameterprodukt, welches das Produkt von kleinsten Strahldurchmesser und Strahldivergenz im Fernfeld ist. Breitet sich ein Lichtstrahl in einem kartesischen x-y-z Koordinatensystem entlang der z-Achse aus, so kann für die x- als auch für die y-Richtung unabhängig ein Strahlparameterprodukt bestimmt werden. Es ist für den durch diverse Optiken geleiteten einzelnen Laserstrahl im besten Fall eine Konstante, im realen Fall wird es größer und somit die Fokussierbarkeit verschlechtert. Für ein Bündel von Laserstrahlen kann mit Optiken, welche die Abstände zwischen den Laserstrahlen verringern, bis zu einem gewissen Grad eine Verkleinerung des gesamten Strahlparameterproduktes erreicht werden.

Die Brillianz ist nun definiert als optische Leistung dividiert durch das Produkt der beiden vorher definierten Strahlparameterprodukte. Je höher die Brillianz, desto höher ist die im Fokus erreichbare maximale Intensität, was neben der optischen Leistung ein Hauptkriterium bei der Beurteilung der Brauchbarkeit eines Lasers für Materialbearbeitung darstellt. Bei Diodenlasern üblicher Bauart, die immer aus vielen Laserdioden aufgebaut sind, kann durch Erhöhung der Anzahl der Laserdioden keine Erhöhung der Brillianz erreicht werden, denn die höhere Gesamtleistung geht aufgrund der größeren Anzahl an optischen Pfaden einher mit einem erhöhten Strahlparameterprodukt. So ergibt beispielsweise die parallele Ausbreitung (Positionsmultiplexing) von zwei Laserstrahlen zwar im Fernfeld keine Erhöhung der Divergenz, dafür aber mindestens eine Verdoppelung des kleinsten Strahldurchmessers, wogegen eine Fokussierung auf einen gemeinsamen Punkt (Winkelmultiplexing) keine Erhöhung des kleinsten Strahldurchmesser ergibt aber die Divergenz im Fernfeld mindestens verdoppelt.

Übliche Methoden zur Strahlführung und -kombination bei Diodenlasern sind Wellenlängen-, Polarisations-, Positions- und Winkelmultiplexing und zur substantiellen Brillianzsteigerung die bis dato nicht auf hohe Leistung skalierbare kohärente Kopplung der Laserdioden. Beim Wellenlängenmultiplexing werden Laserstrahlen verschiedener Wellenlängen in wellenlängenabhängigen Filtern überlagert, wobei derzeit bei Hochleistungsdiodenlasern mangels geeigneter Laserdioden nur maximal drei Wellenlängen (808, 940, 980nm) überlagert werden können, was zu einer dreifachen Brillianzsteigerung führt. Beim Polarisationsmultiplexing werden zwei linear polarisierte Laserstrahlen mit aufeinander normal stehender Polarisation in einem Polarisationsfilter überlagert, was zu einer zweifachen Brillianzsteigerung führt.

Es werden Diodenlaser aus den genannten Gründen in der Technik und der Forschung zunehmend verwendet, obwohl sie die erwähnten Nachteile aufweisen; Die pro Diode emittierte Leistung ist relativ gering, bei Zusammenfassung mehrerer oder einer großen Anzahl von Dioden zu einer gemeinsamen Quelle erhält man nur eine schlechte Strahlqualität, die durch die Überlagerung der Strahlung vieler inkohärent emittierender Laserdioden bedingt ist. Daraus folgt, dass wegen der bei dieser Anordnung relativ großflächigen Quelle bzw, wegen der hohen Anzahl an optischen Pfaden eine Fokussierung des Strahles nicht mit der bei vielen Anwendungsgebieten notwendigen Intensität und Tiefenschärfe (Länge, auf der der Fokusdurchmesser erhalten bleibt) möglich ist.

Es wurde nun in einem nachveröffentlichten Artikel, nämlich in: M.Bartram et.al. [2003] Pulse widths less than 100ns at 500A Current: Challenge to Explore New Applications with High-Power Laser Diode Arrays, Proceedings of the Second International WLT-Conference on Lasers in Manufacturing 2003, Munich, June 2003 festgestellt, dass unter bestimmten Bedingungen auch für kontinuierlichen Betrieb gedachte Laserdioden leistungsstarke Laserpulse erzeugen können, wobei die Frequenz dieser Pulse aber nicht beliebig zu steigern ist, so dass die über längere Zeiten gemittelte Leistungsabgabe dadurch nicht gesteigert werden kann, was bedeutet, dass auch diese Erkenntnis zu keiner Verbesserung der eingangs dargestellten Situation fuhrt Eine 10-fache Pulsüberhöhung ist erreichber, falls die Pulsdauern unter 100ns liegen, Die von der Pulsfrequenz abhängige Durchschnittsleistung sollte allerdings niedriger als im kontinuierlichen Betrieb gewählt werden, um die erhöhte Belastung durch den Pulsbetrieb auszugleichen. Als sicherer Wert erscheint eine Durchschnittsleistung im Pulsbetrieb, die 50% der im kontinuierlichen Betrieb erreichbaren Durchschnittsleistung entspricht.

Ferner existiert eine Mannigfaltigkeit an in der Regel für Messzwecke gedachten Pulslaserdioden, welche aufgrund eine besonderen inneren Strukturierung zur Generierung leistuagsstarker Laserpulse besonders geeignet sind, aber, meist aufgrund schlechter Wärmeableitung, nur eine sehr geringe Durchschnittsleistung erbringen. Solche Laserdioden sind typischerweise mit einer Kavität größerer Querschnittsfläche ausgestattet und in Fällen, die besonders hohe Spitzenleistung erfordern, sind mehrere lichtemittierende pn-Übergänge im Abstand von typischerweise 4 μm übereinander geschichtet. Obwohl im letzteren Fall wieder parallel laufende Laserstrahlen erhalten werden, wird aufgrund des geringen Abstandes trotzdem eine relativ hohe Brillianz erreicht.

Aus der US 5 250 810 A ist eine Vorrichtung zur Bestimmung der Luftverschmutzung bekannt, die auf der Absorption von Licht bestimmter Wellenlänge durch bestimmte Luftverschmutzungen beruht. Um diese Messung durchzuführen, werden Laserstrahlen von einer Laserquelle (CO2-Laser) zu einem Detektor geleitet, wo die Absorption festgestellt und aus den bekannten Betriebsparametern die entsprechende Luftverschmutzung berechnet wird. Für unterschiedlichen Schmutz werden unterschiedliche Wellenlängen und damit unterschiedliche Laserquellen benötigt. Um mehrere Laserstrahlen mit unterschiedlicher Wellenlänge möglichst einheitlich abstrahlen zu können, wird in dieser Druckschrift eine Vorrichtung vorgeschlagen, durch die die einzelnen Laserstrahlen in einem Zeit-Multiplex-System zu einem Strahl vereint werden, wobei mit selektiver Polarisation und gepulst betriebenen Lasern gearbeitet wird. Die einzelnen, immer zu unterschiedlichen Zeitpunkten erzeugten, linear polarisierten Laserpulse werden dabei paarweise, jedoch aufgrund des unterschiedlichen Erzeugungszeitpunkts immer zeitversetzt, durch polarisationsselektive optische Elemente einen gemeinsamen Pfad geleitet und anschließend durch schaltbare Polarisationsdreher in die passende Polarisationsrichtung gebracht, um beim nächsten optischen Vereinigungselement wiederum in der richtigen Polarisationsrichtung vorzuliegen. So können in einzelnen Stufen die Lichtpfade schrittweise vereint werden.

Durch diese Vorrichtung wird es möglich, einen, durch die Schaltvorgänge natürlich intermittierenden, Laserstrahl zu schaffen, der (entlang seiner Länge gesehen) aus einzelnen Abschnitten besteht, die unterschiedliche Wellenlänge aufweisen. Die Intensität der einzelnen Strahlenabschnitte entsprechen der Pulsleistung des jeweiligen Lasers, und der gesamte Strahl, hat, wenn man die Pausen zwischen den einzelnen Abschnitten nicht berücksichtigt, eine der Pulsspitzenleistung eines einzelnen Laser entsprechende Durchschnittsleistung. Wenn man die Pausen ebenfalls berücksichtigt, so ist der erhaltene Laserstrahl selbstverständlich entsprechend dem Tastverhältnis schwächer.

Die US 2002/000426 A1 offenbart ein Verfahren zum Herstellen von Bohrungen in einem Multi-Layer Substrat Werkstück, z.B. elektronische Prints, Halbleiterstrukturen und dgl.. Zu diesem Zweck enthält die Vorrichtung zwei oder mehrere Lasersysteme, die in Form gepulster Laserquellen zum Einsatz kommen. Die zu unterschiedlichen Zeiten emittierten Laserpulse werden auf elektrooptischem Wege mittels eines Polarisators auf einen Pfad gelenkt. Ziel dieses Verfahrens ist es unter Zuhilfenahme mehrere Laser einen einzigen gepulsten Laserstrahl zu erlangen.

Ähnlich wie bei vorangegangener Druckschrift werden die einzelnen jeweils zu unterschiedlichen Zeitpunkten erzeugten Laserpulse auf einen einzigen Lichtpfad gelenkt. Die Leistung des ausgehenden Laserstrahls kann lediglich dadurch beeinflusst werden, dass die Intervalle zwischen den Laserpulsen kürzer gewählt werden. Dabei stößt man jedoch bei gepulsten Lasern schon bald auf Grenzen.

Es ist nun das Ziel der Erfindung, die sich aus dem Stand der Technik ergebenden Nachteile zu beseitigen und einen Laserstrahl zu schaffen, dessen Quelle eine Vielzahl von Laserdioden ist und der eine bessere Strahlqualität aufweist als die bisher bekannten, ebenfalls eine Vielzahl von Laserdioden verwendenden Diodenlaser es ermöglichen, und gleichzeitig auch die Gesamtleistung des entstehenden Laserstrahl in Bezug auf die Einzellaserquellen deutlich zu erhöhen.

Erfindungsgemäß werden diese Ziele dadurch erreicht, dass jeweils zwei Laserquellen mit unterschiedlicher Polarisierung gleichzeitig aktiviert werden und der optische Multiplexer aus einer Kaskade im Strahlengang aufeinanderfolgender, in n + 1 Stufen angeordneter polarisationsselektiver optischer Elemente und jeweils zwischen diesen Stufen angeordneter, schaltbaren Polarisationsdreherstufen besteht, wobei entweder in jeder Polarisationsdreherstufe für jeden Pfad ein schaltbarer Polarisationsdreher vorgesehen ist oder die Zahl der Polarisationsdreher in einer Polarisationsdreherstufe geringer ist als die Pfadanzahl und somit optische Pfade gemeinsam durch Polarisationsdreher geleitet werden oder jede Polarisationsdreherstufe aus einem einzigen alle Pfade umfassenden schaltbaren Polarisationsdreher besteht.

Es werden also jeweils die Laserimpulse einer vertikal polarisierten und einer horizontal polarisierten Diode zeitgleich abgestrahlt. Die einzelnen Teilstrahlen werden dabei durch doppelbrechende Kristalle, Polarisationsprismen oder polarisationsselektive Spiegel in schaltbare Polarisationsdreher, beispielsweise Pockelszellen oder Faradayrotatoren, gelenkt, in diesen in eine vorgegebene Polarisationsrichtung gebracht (d.h. um 90° gedreht oder nicht gedreht), um von den nächsten Strahlvereinigern in die nächsten schaltbaren Polarisationsdreher gelenkt zu werden, in denen wieder die Polarisation für die nächste Stufe angepasst wird. In der letzten polarisationsselektiven Stufe erfolgt dann die Vereinigung der beiden so erhaltenen Laserpulse auf einen gemeinsamen optischen Pfad. Sind die Laserpulse zu Ende, so werden die Polarisationsdreher in einen anderen Schaltzustand gebracht, sodass zwei weitere Laserdioden vertikal und horizontal polarisierte Laserpulse abstrahlen können, und diese Laserpulse die Apparatur wieder auf dem selben optischen Pfad verlassen, wie zuvor.

Durch die Kombination dieses Verfahrens, nämlich des Verfahrens zum Betrieb der einzelnen Laserdioden, und einer Vorrichtung, wie sie im nachfolgenden beschrieben wird, nämlich der Vorrichtung zur Vereinigung von Laserstrahlen, und passender Kopplung der Parameter der Vorrichtung und des Verfahrens, kann ein Laserstrahl, hoher Leistung geschaffen werden, der darüber hinaus auch eine hohe Strahlqualität aufweist.

Um zu einem besseren Verständnis der Erfindung zu kommen wird im folgenden auch der dafür erforderliche technische Hintergrund näher beleuchtet Es wird also mit einer Mehrzahl von Laserdioden eine vorbestimmte Folge von Laserpulsen erzeugt, welche mit einer optischen Strahlzusammenführung auf einen gemeinsamen optischen Pfad geführt werden. Der resultierende Laserstrahl besteht somit aus einer auf einer Bahn laufenden Folge von Laserpulsen unterschiedlicher Herkunft und kann daher so gut fokussiert werden wie ein gewöhnlicher Laserstrahl. Er erreicht dabei, je nach der möglichen Leistungsüberhöhung einer Laserdiode im Pulsbetrieb, eine Durchschnittsleistung, die je nach zeitlichem Abstand zwischen zwei Pulsen nur etwas kleiner als die Pulsspitzenleistung einer Laserdiode ist.

Aufgrund der oben erwähnten, nachveröffentlichten Schrift: M.Bartram et.al. [2003] Pulse widths less than 100ns at 500A. Current kann von einer 10-fachen Leistungsüberhöhung einer Laserdiode im Pulsbetrieb ausgegangen werden, sodass mit diesem Verfahren, welches eine Durchschnittsleistung liefert, die der Pulsspitzenleistung einer Laserdiode entspricht, eine im Vergleich zu einer Laserdiode 10fach höhere Strahlleistung erreicht werden kann. Da aber sämtliche Laserpulse auf einer Bahn laufen, ist das Strahlparameterprodukt des so entstandenen Laserstrahls gleich dem Laserstrahl, wie er von einer Laserdiode emittiert wird. Somit wird mit dem Verfahren eine 10-fache Brillianzsteigerung erreicht. Eine typische Hochleistungslaserdiode erreicht eine maximale Durchschnittsleistung von 5 W (Watt). Somit kann mit solchen Laserdioden mit dem genannten Verfahren ein Laserstrahl von etwa 50 W Leistung geschaffen werden, mit einer Fokussierbarkeit, wie sie üblicherweise der Einzelstrahl einer Laserdiode besitzt. Geht man davon aus, dass solche Laserdioden im Pulsbetrieb bis zu 50% ihrer kontinuierlichen Leistung liefern können, so sind 25 Laserdioden, die je 2,5 W Durchschnittsleistung im Pulsbetrieb liefern, notwendig, um die anvisierten 50 W Gesamtleistung zu erreichen.

Zur Realisierung eines optischen Zeit-Multiplexers eignet sich im Prinzip jeder optische Scanner, der einen Laserstrahl abzulenken imstande ist und der auch in umgekehrter Richtung betrieben werden kann. Da eine signifikante Pulsüberhöhung bei Laserdioden nur bei Pulsdauern in der Größenordnung von 100 ns (Nanosekunden) zu erzielen ist und auch eine hohe Anzahl an Laserdioden adressierbar sein soll, sind nur sehr schnell schaltbare Scanner mit einem hohen Ablenkungsbereich bzw. vielen verschiedenen erreichbaren optischen Pfaden verwendbar. Aufgrund einfacherer Steuerung sind digitale Scanner, die prinzipbedingt nur eine diskrete Anzahl von optischen Pfaden adressieren, analogen Scannern, die einen kontinuierlichen Bereich bedienen, vorzuziehen, da bei letzteren eine Abweichung der Steuerparameter von den Sollwerten sofort eine Ungenauigkeit und Auffächerung des zu erzielenden Laserstrahles nach sich zieht.

Von den vielen Möglichkeiten einen Lichtstrahl abzulenken, kommen aufgrund der notwendigen kurzen Schaltzeiten hauptsächlich elektrooptische und magnetooptische Verfahren in Frage. Mit genügend schnellen optischen Schaltern, die aber nur eine geringe Anzahl von m (m = 2, 3, 4, ..) verschiedenen Wegen adressieren können, kann durch eine Kaskadierung dieser optischen Schalter eine entsprechende Erhöhung der Wegeanzahl und damit der einsetzbaren Diodenlasern erreicht werden. Setzt man an die m Ausgänge eines optischen Schalters, die Eingänge von m weiteren optischen Schalter mit jeweils m Ausgängen, so können schon $m^2$ verschiedene Wege geschalten werden, beziehungsweise die Laserpulse von $m^2$ Laserdioden auf einen gemeinsamen Weg geführt werden.

Hat man im besonderen digitale optische Schalter mit nur zwei Ausgängen zur Verfügung, kann nach diesem Prinzip ein digitaler Scanner mit $2^n$ (n = 1, 2, 3... = Anzahl der Kaskadierungen, wobei n = 1 der Verwendung nur eines Schalters entspricht) schaltbaren optischen Pfaden realisiert werden. Eine einfache Realisierungsmöglichkeit eines schnellen digitalen optischen Schalters für linear polarisiertes Licht ist gegeben durch eine Kombination eines schaltbaren Polarisationsdrehers (Pockelszelle, Faradayrotator) und einer im Strahlengang darauf folgenden polarisationsselektiven Optik, in der das Licht je nach dem im Polarisationsdreher erhaltenen Polarisationszustand auf zwei verschiedene Wege geleitet werden kann.

Unter einer Pockelszelle wird in dieser Anmeldung und den Ansprüchen ein elektrooptisch aktivierbares Material, welches so in den Strahlengang eingebracht ist, dass das Anlegen einer bestimmten Spannung an am Material befestigten Elektroden zu einer Polarisationsdrehung des durchgehenden Lichts um 90° fuhrt, verstanden.

In der optischen Nachrichtentechnik werden integrierte, nur für geringste Lichtleistungen geeignete Monomode-Wellenleiter zur Signalübertragung benutzt und optische Schalter (Weichen) werden üblicherweise als Mach-Zehnder-Modulator oder als Richtkopplencha1-ter (directional coupler switches) aufgebaut. Durch Kaskadierung von optischen Schaltern werden der Nachrichtentechnik optische n x n - Schalter mit n Eingängen und n beliebig adressierbaren Ausgängen realisiert. Diese können auch als optische Multiplexer betrieben werden, wenn alle Eingänge auf einen Ausgang geleitet werden, was sich im Betrieb in einem Nachrichtennetzwerk zufällig ergeben kann, allerdings aufgrund der konstruktionsbedingt geringen übertragbaren optischen Leistung keinerlei Vorteil im Hinblick auf eine hohe Laserleistung mit sich bringt. Tatsächlich beruhen in der optischen Nachrichtentechnik die meisten optischen Schalter wie Mach-Zehnder-Modulatoren oder Richtkoppler (directional coupler) auf den speziellen Eigenschaften von integrierten Monomodewellenleitern, welche nur geringe Laserleistung sehr hoher Strahlqualität transportieren können und somit für die multimodigen Hochleistungslaserdioden nicht in Betracht kommen.

Eine weitere Möglichkeit zur Realisierung eines digitalen Schalters für hohe Laserleistung geringer Strahlqualität ist die Verwendung der in "Electrooptics, F.Agullo-Lopez et al, 1994, Academic Press" beschriebenen elektrooptischen Bragg-Modulatoren bzw. Bragg-Schaltern, in denen (schief) einfallendes Licht an einem durch einen elektrooptischen Effekt erzeugtem Bragg-Spiegel je nach Schaltzustand reflektiert oder transmittiert wird. Ein Bragg-Spiegel besteht aus einer Folge von Schichten mit wechselndem Brechungsindex, welche im Falle des Bragg-Schalters durch geeignet strukturierte und mit Spannung beaufschlagte Elektroden erzeugt werden. Die zu wählende Schichtdicke hängt von der Wellenlänge und dem Einfallswinkel des Lichts ab. In der DE 196 43 489 C1, betreffend einen Bragg-Modulator ist ein Verfahren beschrieben, mit dem ein solcher schaltbarer Bragg-Spiegel in einem planaren, Wellenleiter erzeugt werden kann. Dies ist besonders für Hochleistungalserdioden geeignet, da diese in einer Richtung (normal auf den lichterzeugenden pn-Übergang) über eine sehr gute Strahlqualität Verfügen, während die andere Richtung eine sehr schlechte Strahlqualität hat. Dies ist optimal für planare Wellenleiter, für die das eingekoppelte Licht nur in einer Richtung von guter Strahlqualität sein muss.

Zu erwägen sind auch sogenannte analoge Scanner, die Licht sogar um einen beliebigen in einem bestimmten Bereich liegenden Winkel ablenken können und somit mit geeigneter Ansteuerung auch m (m = 2, 3, 4 ...) verschiedene diskrete Wege bedienen können. Ein solcher Scanner ist beschrieben in der DE 43 26 196 A1 betreffend einen planaren elektrooptischen Lichtstrahlablenker und ein Verfahren zu seiner Herstellung. Hier werden Prismenarrays benutzt, deren Brechungsindices durch eine Steuerspannung beeinflusst wird, so dass die an der Schrägseite der Prismen gebrochene Strahlung eine von der Steuerspannung abhängige Ablenkung erfährt. Entweder kann das Prismenarray normal auf das abzulenkende Licht stehen, so dass also alle Prismen parallel vom Licht durchflutet werden, oder das Array steht in Lichtrichtung, so dass ein Prisma nach dem anderen durchstrahlt wird, um den in jedem Prisma erreichten Ablenkwinkel zu summieren.

Die Inhalte der beiden oben genannten Patenschriften beruhen auf dem Verfahren der Domäneninversion in ferro-elektrischen Materialien (im besonderen Lithiumniobat und -tantalat aber auch Halbleitermaterialien), welche die Ausbildung der angeführten Strahlablenker in planarer Wellenleitertechnik gestatten und somit ideal für die Verwendung von Laserdioden geeignet sind.

Ein weiteres Prinzip eines analogen Scanners findet sich in der DE 101 02 723 A1, betreffend einen Strahlablenker. Schaltanordnung mit Strahlablenkern zum wahlweisen Verknüpfen von Anschlüssen für optische Signale. Hierbei ist ein elektrooptisches Material zwischen dielektrischen Spiegelschichten angebracht und erhält mittels besonders strukturierten Elektroden eine ortsabhängige Änderung des Brechungsindex, welche zur Beeinflussung des Reflektionswinkels eines einfallenden Lichtstrahles benutzt werden kann. Es handelt sich also um eine Art Spiegel, dessen Reflektionswinkel in einem bestimmten Bereich beliebig gewählt werden kann. Die Schrift fuhrt auch eine Anordnung solcher Ablenker an, die als optische Schaltmatrix benutzt werden kann und somit auch als optischer Multiplexer ausgeführt werden kann.

Die zusätzliche Verwendung von Wellenlängen- und Polarisationsmultiplexing erlaubt dann eine weitere Leistungs- und Brillianzsteigerung, Mit Winkel- und Positionsmultiplexing können in weiterer Folge theoretisch beliebige Leistungen erreicht werden, wobei sich dann allerdings das Strahlparameterprodukt entsprechend erhöhen würde, und keine weitere Brillianzsteigerung erzielt würde.

Nützt man also noch zusätzlich Wellenlängen- und Polarisationsmultiplexing aus, d.h. man kombiniert mit diesen Verfahren die Ausgänge von mehreren optischen Multiplexern, so sind prinzipiell die Schaltzyklen der verschiedenen Multiplexer unabhängig voneinander. Vorteilhafter weise wird man allerdings nur einen Treiber benutzen, sodass dann alle Multiplexer synchron arbeiten.

Hervorzuheben ist beispielsweise die Möglichkeit, die linear polarisierten Ausgänge von zwei mit kaskadierten elektrooptischen Braggreflektroren realisierten Multiplexern mittels einer polarisationsselektiven Optik nochmals auf einen gemeinsamen Pfad zu führen.

Einer besonderen Behandlung bedarf der Fall, dass die linear polarisierten Ausgänge von zwei mit schaltbaren Polarisationsdrehern realisierten Multiplexern mittels einer polarisationsselektiven Optik nochmals auf einen gemeinsamen Pfad geführt werden. Dies ergibt sich nämlich in naheliegender Weise, da ja schon in den Multiplexern selbst Polarisationsmultiplexing ausgenützt wird. In diesem Fall können die beiden Multiplexer eine Einheit bilden.

Das Wesen der Erfindung besteht darin, dass jeweils die Laserimpulse einer vertikal polarisierten und einer horizontal polarisierten Diode zeitgleich abgestrahlt werden. Wie bereits weiter oben erwähnt werden die einzelnen Teilstrahlen dabei durch doppelbrechende Kristalle, Polarisationsprismen oder polarisationsselektive Spiegel in schaltbare Polarisationsdreher, beispielsweise Pockelszellen oder Faradayrotatoren, gelenkt.

Ein schaltbarer Polarisationsdreher kann auch aus einer Kombination Pockelszellelamda/2-Platte oder der Kombination Faradayrotator-45°-Dreherplatte aufgebaut sein. Im ersten Fall macht die lamda/2-Platte aus dem einfallenden linear polarisiertem Licht zirkular polarisiertes Licht, welches in Folge bei positiver Viertelwellenspannung (beträgt die Hälfte der Halbwellenspannung) an der Pockelszelle diese mit um 90° gedrehter Polarisation verlässt und bei negativer Viertelwellenspajmung wieder in die ursprüngliche Polarisationsrichtung gebracht wird. Analog ist auch die Funktionsweise der zweiten Kombination zu verstehen.

Bei der Kaskadierung von digitalen Schaltern (2x1-Schaltern) gibt es vorteilhafte Möglichkeiten alle Schaltzustände durchzuschalten. Dabei werden die einzelnen Kaskadierungstufen mit fixen Frequenzen aus und eingeschaltet, wobei die verwendeten Frequenzen Vielfache voneinander sind und in zueinander festen Phasenlagen auf die Kaskadierungsstufen angewandt werden. Die folgende Diskussion beschränkt sich auf digitale Schalter realisiert aus einer Kombination Polarisationsfilter und schaltbarer Polarisationsdreher kann aber zu weiten Teilen auch auf andere digitale Schalter wie im besonderen die Bragg-Schalter angewandt werden, im besonderen was die Schaltsequenzen und die Art und Erzeugung der erforderlichen Steuerspannungen betrifft.

Die Erfindung wird im folgenden an Hand der Zeichnung näher erläutert. Dabei zeigt die einzige Figur den prinzipiellen Aufbau einer Vorrichtung, welche die Ausführung des erfindungsgemäßen Unfahrens ermöglicht.

Die Figur zeigt schematisch, nicht unbedingt geometrisch, eine Anordnung, bei der sechzehn Laserdioden 1, 2, ...16 und die im folgenden beschriebenen optische Vorrichtung so angeordnet sind, dass die von den Laserdioden 1, 2, ...16 kommenden, gepulsten Laserstrahlen zu einem einzigen aus der Vorrichtung entlang des optischen Pfades OP austretenden Laserstrahl vereint werden.

Um dies zu erreichen ist folgende Vorrichtung vorgesehen: Die mit ungeraden Zahlen bezeichneten Laserdioden 1, 3, 5, ...15 emittieren vertikal polarisiertes Laserlicht und die mit geraden Bezugszeichen bezeichneten Laserdioden 2, 4, 6, ...16 horizontal polarisiertes Licht. Damit ist auch gemeint, dass zusätzliche in der Figur nicht gezeigte optische Elemente die Polarisation des von den Laserdioden emittierten Lichts in die erforderliche Lage bringen. Das von den Laserdioden 1, 2, ...16 emittierte Licht fällt auf polarisationsselektive Elemente PS4, beispielsweise passend angeordnete doppelbrechende Kristalle, Polarisationsprismen oder polarisationsselektive Spiegel, welche geeignet sind, zwei einfallende Laserstrahlen mit aufeinander orthogonal stehender linearer Polarisation in einen gemeinsamen, ausfallenden Laserstrahl zu vereinigen. Somit werden die ursprünglich 16 optischen Pfade auf acht Pfade reduziert.

Die auf diesen acht Pfaden laufenden Laserpulse gelangen sodann in eine Polarisationsdrehstufe PD3, in der die Polarisationsrichtung des durchgehenden Lichtes je nach dem Aktivierungszustand des Elementes entweder unverändert bleibt oder um 90° gedreht wird.

Durch diese aus den beiden Elementen PS4 und PD3 bestehenden Vereinigungsstufe gelangt man von sechzehn zu acht Laserstrahlen, deren Polarisationsrichtung durch die Elemente PD3 den gewünschten Wert (als die Allgemeinheit nicht beschränkende Konvention sei vertikal und horizontal angenommen) aufweist. Auf gleiche Weise wie die Reduzierung der sechzehn Laserstrahlen in der gesamten Stufe PS4, PD3 erfolgt in der nächsten Stufe, durch polarisationssensitive Elemente PS3 und polarisationsdrehende Elemente PD2, die Reduzierung und passende Polarisation auf vier Strahlen. In der nächsten Stufe, bestehend aus den polarisationssensitiven Elementen PS2 und dem polarisationsdrehenden Elementen 1 erfolgt die Vereinigung auf zwei Strahlen, in der letzten Stufe, die nur aus dem eigentlichen Strahlvereinigungselement PS1 besteht, die Kombination der ursprünglichen sechzehn optischen Pfade zu nur einem optischen Pfad mit dem Bezugszeichen OP.

Jede der Polarisationsdreherstufen PD1...3 kann mit einem schaltbaren Polarisationsdreher realisiert werden, oder es kann jede Polarisationsdreherstufe aus mehreren Polarisationsschaltem bestehen. In gleicher Weise können die polarisationsselektiven Stufen PS1...4 aus einem oder mehreren polarisationsselektiven Elementen bestehen. Ebenso können bei der Kaskadierung von anderen optischen Schaltern, diese in den Kaskadierungsstufen zusammengefasst werden. Ob dies möglich ist, hängt vor allem vom Verhältnis der Querschnittsfläche der Laserstrahlen zur Apertur der Schalter ab.

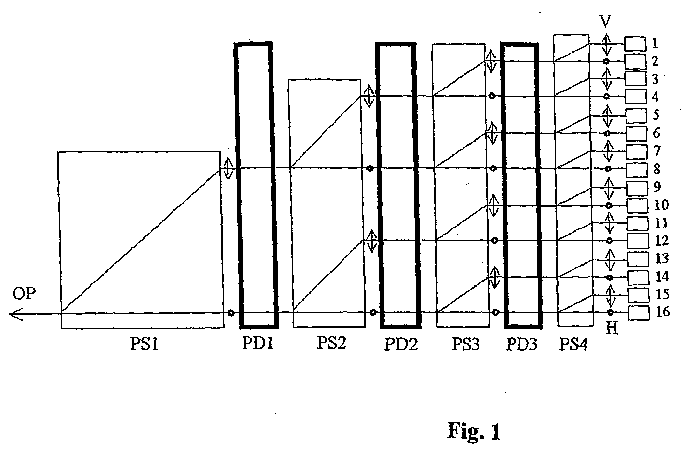

In der Fig. 1 sind die Polarisationsebenen der Laserdioden 1, 2, ...16 durch in der Zeichenebene liegende Doppelpfeile für vertikal V und durch Ringe, die aus der Zeichenebene ragende Doppelpfeile andeuten sollen, für horizontale Polarisation H eingezeichnet Gleichermaßen sind die jeweiligen Polarisationsebenen nach den einzelnen Vereinigungsstufen angegeben, die schließlich zum aus der Vorrichtung entlang des optischen Pfades OP austretenden Laserstrahl führen.

In Fig. 1 ist die Anordnung für sechzehn Laserdioden dargestellt, die Erfindung ist für eine beliebige Anzahl von Laserdioden durchführbar, wobei wegen der jeweiligen Halbierung der Anzahl der Strahlengänge pro Bearbeitungsstufe eine Anzahl von $2^{n+1}$ Laserdioden optimal ist, wobei n eine ganze, positive Zahl darstellt.

Im dargestellten Ausführungsbeispiel sind jeweils die mit ungeraden Bezugszeichen versehenen Laserdioden 1, 3, ...15 so angeordnet oder so mit entsprechenden optischen Elementen ergänzt, dass sie vertikal polarisiertes Licht aussenden, die mit geraden Bezugszeichen 2, 4 ...16 bezeichneten Laserdioden senden horizontal polarisiertes Licht aus. Die jeweiligen Polarisationsrichtungen nach dem Durchgang durch ein Polarisationsdrehelement sind in der Fig. 1 ebenfalls eingezeichnet.

Des weiteren sei die Möglichkeit erwähnt, die Polarisationsdreherelemente einer Polarisationsdreherstufe getrennt voneinander, aber mit einer festen Phasen- und Frequenzbeziehung zueinander aus- und einzuschalten. Dies ermöglicht im Falle, dass in jeder Stufe für jeden optischen Pfad ein Polarisationsdreher mit einer Pockelszelle realisiert ist, jede Pokkelszelle mit einem in einem Schwingkreis erzeugten rein harmonischen Spannungsverlauf zu beaufschlagen, wie nun erklärt wird.

Bei Deaktivierung aller Polarisationsdrehelemente kann gleichzeitig das Licht der Laserdiode 1 und der Laserdiode 16 zusammengeführt werden. Wenn nun die Polarisationsdreherstufe PD1 mit einer vorgegebenen Frequenz f aktiviert bzw. deaktiviert wird, die Polarisationsdreherstufe PD2 phasengleich mit der halben Frequenz f/2 und die Polarisationsdreherstufe PD3 phasengleich mit der Frequenz f/4 betrieben wird, so ergeben sich der Reihe nach $2^n$, (für n = 3) somit acht Schaltzustände:

| | | | |
|---|---|---|---|
| 000 (1,16) | 100 (8,9) | 010 (4,13) | 110 (5,12) |
| 001 (2,15) | 101 (7,10) | 011 (3,14) | 111 (6,11) |

Dabei bedeutet beispielsweise 101 (7,10), dass die Polarisationsdreherstufen (PD1) und (PD3) eingeschaltet sind und die Laserdioden 7 und 10 an der Reihe sind. Das Schalten mit konstanter Frequenz ermöglicht es, die Impedanz jedes Polarisationsdrehers in einem selbsterregten oder resonant angeregtem elektrischem Schwingkreis zu nutzen und so die erforderliche Modulation der Spannungen oder Ströme zu erreichen.

Ist in dem oben angeführten Fall in den Polarisationsdreherstufen jedem optischen Pfad ein eigener Polarisationsdreher zugeordnet, so dass also PD1 mit zwei, PD2 mit vier und PD3 mit acht Polarisationsdrehern realisiert sind, so können im Falle der Verwendung von Pokkelszellen, welche spannungsgesteuert sind, alle Spannungsverläufe harmonisch sein, was im folgenden erklärt wird. Die Polarisationsdreher von PD1 müssen dann nach jedem Puls innerhalb der Schaltpause umgeschaltet werden. Bei der Verwendung von Pockelszellen ist bei Einfall von linear polarisiertem Licht für eine 90°-Polarisationsdrehung die Halbwellenspannung $U_{\lambda/2}$ anzulegen. Die Abhängigkeit vom Quotienten von Lichtleistung $P_{out}$ der gewünschten Polarisation zur Lichtleistung der ursprünglichen Polarisation $P_{in}$ vom Quotienten der angelegten Spannung U zur Halbwellenspannung ist von der Form

$$\frac{P_{out}}{P_{in}} = \sin^2\left(\frac{\pi}{2}\frac{U}{U_{\lambda/2}}\right).$$

Der Wert des Quotienten $P_{out}/P_{in}$ muss für die Pockelszellen von PD1 periodisch zwischen 0 (U=0) und 1 $(U=U)_{\lambda/2})$ wechseln. Es ergibt sich nun aufgrund der oben angeführten Relation die Möglichkeit, auch harmonische um die halbe Halbwellenspannung oszillierende Spannungsverläufe an die Pockelszelle anzulegen, da bei einer geeignet gewählten Schwingungsamplitude ein periodischer Rechteckverlauf von $P_{out}/P_{in}$ gut angenähert wird. Wählt man beispielsweise die Pulsdauern der Laserdioden mit 100ns und die Pulspausen ebenfalls mit 100ns, so ist, wenn die Pulse jeweils auf Wellenberg und Wellental der harmonischen Spannung zentriert und exakt vom rechteckförmigen Zeitverlauf sind, während der Pulsdauer die Abweichung des Quotienten $P_{out}/P_{in}$ vom Sollwert 0 oder 1 so gering, dass ein sehr geringer Teil der durchgehenden Strahlung nicht die notwendige Polarisation erhält.

Dies ist leicht einzusehen, wenn man sich vergegenwärtigt, dass bei einer Abweichung der Spannung U um $U_{\lambda/2}/10$ vom Sollwert 0 oder $U_{\lambda/2}$ nur 2.4% der Lichtleistung nicht die gewünschte Polarisation erhalten. Integriert man die gesamten Verluste über die Pulsdauer, so ergibt sich für das angegebenen Tastverhältnis für eine optimale Schwingungsamplitude von $1.1^*U/U_{\lambda/2}$ ein Verlust von 0.58%. Bei einer Pulsdauer von 100ns und einer Pause von 50ns ist die optimale Amplitude $1.17^*U/U_{\lambda/2}$ bei 2% Verlust und bei einer Pulsdauer von 100ns und einer Pause von 33ns ist die optimale Amplitude $1.2^*U/U_{\lambda/2}$ bei 3.2% Verlust. Natürlich ist bei einer Veränderung des Tastverhältnis jeweils die Schwingfrequenz entsprechend anzupassen. Der große Vorteil ist, dass Pockelszellen üblicherweise sehr hohe Schaltspannung benötigen und das direkte hochfrequente Schalten dieser Spannung mit Transistoren viel elektrische Leistung benötigt, wohingegen die harmonischen Spannungsverläufe mit verlustarmen LC-Schwingkreisen realisiert werden können, wobei die Eigenkapazität der Pockelszellen als Kapazität des zugehörigen LC-Schwingkreises verwendet werden kann.

Bei den Polarisationsdreherstufen PD2 und PD3 steht für jeden Polarisationsdreher nach jedem Puls eine deutlich längere Zeit zum Umschalten zur Verfügung, da die dann erzeugten Laserpulse durch die anderen Polarisationsdreher von PD2 und PD3 durchgehen. Offensichtlich können in diesem Fall harmonische Spannungsverläufe noch mit weit geringeren optischen Verlusten verwendet werden, als im Falle der beiden Polarisationsdreher von PD1. Es haben dann allerdings die Spannungsverläufe der Pockelszellen einer Stufe zwar gleiche Frequenzen aber verschiedene Phasen, so dass bei jeder Pockelszelle die Spannungsmaxima bzw. -minima gerade dann erreicht werden, wenn ein Laserpuls durchläuft.

**EP 1 588 462 B1**

Faradayrotatoren, welche stromgesteuert sind, zeigen dieselbe Durchlasscharakteristik wie Pockelszellen, wenn man die Spannungen durch Ströme ersetzt. Da sich bei Faradayrotatoren das magneto-optische Material innerhalb einer Drahtwicklung befindet, ist deren Verhalten in einem elektrischem Netzwerk vor allem induktiv, während Pockelszellen kapazitiv sind. Es ergibt sich daher die Möglichkeit Pockelszellen und Faradayrotatoren gleichzeitig in einem optischen Multiplexer zu verwenden und mit diesen Schwingkreise zu schaffen, welche so abgestimmt sind, dass bei den Spannungsmaxima bzw. -minima die Pockelszellen mit der notwendigen Steuerspannung beaufschlagt sind und von Laserpulsen passiert werden und dass bei den Strommaxima bzw. -minima die Faradayrotatoren mit den notwendigen Steuerströmen versorgt sind und von Laserpulsen passiert werden. In der Figur 1 würde das beispielsweise bedeuten, dass die den Laserdioden 1-8 zugeordneten optischen Pfade durch Faradayrotatoren und die den Laserdioden 9-16 zugeordneten optischen Pfade durch Pockelszellen laufen. In jeder Polarisationsdreherstufe bilden dann die Polarisationsdreher Schwingkreise in denen die nötigen Spannungs- und Stromverläufe generiert werden. Es würden dann im Betrieb nicht zeitgleich zwei Laserdioden aktiviert sondern zeitlich versetzt eine Laserdiode der Gruppe 1-8 und eine Laserdiode der Gruppe 9-16, so dass eben in jeder Gruppe die Aktivierung der Laserdioden phasenrichtig zu den Spannungs- bzw. Strommaxima oder -minima der Polarisationsdreher erfolgt.

Die harmonischen Spannungs- und Stromverläufe in den LC-Schwingkreisen können mit Hilfe von nichtlinearen Elementen (verursacht z.B. durch stromabhängige Induktivitäten oder spannungsabhängige Kapazitäten) in der Art beeinflusst werden, dass die Spannungs- und Stromverläufe sich Rechteckschwingungen annähern und die Schaltpausen zwischen den Laserpulsen kürzer gewählt werden können.

Auch Bragg-Schalter haben dieselbe Durchlasscharakteristik wie Pockelszellen und können daher in einem optischen Multiplexer ebenso mit harmonischen Spannungen geschaltet werden. Allerdings können die erforderlichen Spannungen bei Realisierung in planarer Wellenleitertechnik so gering sein, dass ein direktes Schalten der Steuerspannungen mittels Transistoren vorteilhafter ist.

Natürlich gibt es viele Schaltschemas, bei denen die verschiedenen Polarisationselemente periodisch mit untereinander festen Frequenz- und Phasenbeziehungen aus- und eingeschalten werden können und dabei alle möglichen Schaltzustände periodisch durchgeschaltet werden. Beispielsweise kann eine Polarisationsdreherstufe (PS1,2 od. 3) mit der Frequenz (f), eine zweite ebenfalls mit der Frequenz (f) aber mit einer Phasenverschiebung von 90° zur ersten Schaltsequenz und die dritte mit der halben Schaltfrequenz (f/2) betrieben werden. Für das obige Beispiel kann sich dann folgende Schaltreihenfolge ergeben:

$$000 (1,16) \quad 010 (4,13) \quad 110 (5,12) \quad 100 (8,9)$$
$$001 (2,15) \quad 011 (3,14) \quad 111 (6,11) \quad 101 (7,10)$$

Ebenso kann eine Polarisationsdreherstufe (PS1,2 od. 3) mit der Frequenz (f), eine zweite ebenfalls mit der Frequenz (f) aber mit einer Phasenverschiebung von 90° zur ersten Schaltsequenz und die dritte mit der Schaltfrequenz (2f) und 45° Phasenverschiebung betrieben werden. Dies kann dann folgende Schaltreihenfolge ergeben:

$$100(8,9) \quad 101(7,10) \quad 111(6,11) \quad 110 (5,12)$$
$$O10 (4,13) \quad 011 (3,14) \quad 001 (2,15) \quad 000 (1,16)$$

Dies ist die Schaltsequenz mit den niedrigsten Schaltfrequenzen und daher dem niedrigsten Energieverbrauch, so dass sich für eine Periode nur 8 (=$2^3$) Schaltvorgänge ergeben, was ja auch der Anzahl der Schaltzustände entspricht.

Die Frequenz f richtet sich dabei nach der Anzahl der verwendeten Laserdioden 1, 2, ...16, der maximalen Länge der von den einzelnen Laserdioden abgegebenen Impulse und der Frequenz, in der diese Impulse im Dauerbetrieb generiert werden können. Dazu kommt noch die Zeitspanne, die für das vollständige Umschalten der Polarisationsdrehelemente benötigt wird. Diese Größen und die Abschwächung der Strahlen in den einzelnen optischen Elementen bestimmen neben den zur Verfügung stehenden Laserdioden und der angestrebten Leistung des Laserstrahles den Aufbau der Vorrichtung.

Als polarisationssensitives Element PS kann im Grunde jedes optische Gerät oder Material, das einen unpolarisierten Strahl in zwei zueinander orthogonal linear polarisierte Teilstrahlen zerlegt, wie beispielsweise doppelbrechende Kristalle, Polarisationsprismen oder polarisationsselektive Spiegel verwendet werden. Als physikalische Begründung soll einfach auf die Umkehrbarkeit des Strahlengangs hingewiesen werden.

Betreffend die polarisationssensitiven Elemente PS, die oben genannten Pockelszellen oder Faradayrotatoren wird auf "Laser, J.Eichler et. al., 2002, Springer-Verlag", "Electrooptics, F.Agullo-Lopez et al, 1994, Academic Press" oder "Handbook of Optics, Vol. II, M.Bass et al, 1995, Mc Graw Hill" hingewiesen.

Betreffend des Standes der Technik der Diodenlaser sei auf "High-Power Diode Lasers, R. Diehl et al., 2000, Springer Verlag" hingewiesen.

**EP 1 588 462 B1**

Das geschilderte Prinzip des Zeitmultiplexings kann im Prinzip für jede Art von elektromagnetischer Strahlung, für die gepulste Quellen zur Verfügung stehen, verwendet werden. Da die vorliegende Anmeldung sich auf Diodenlaser konzentriert, wird unter Licht bzw. Laserlicht nicht nur sichtbares Licht verstanden, sondern jene elektromagnetische Schwingungen im Wellenlängenbereich von 300 nm bis 2000 nm, in welchem Laserdioden signifikante Leistungen erreichen.

Es sei noch darauf hingewiesen, dass prinzipiell jeder Lasertyp für das Verfahren in Frage kommt, sofern im Pulsbetrieb eine signifikante Leistungsüberhöhung erzielbar ist, was eine Eigenschaft der meisten Lasertypen ist.

In der selben Weise wie mit Laserdioden können dann sehr leistungsstarke gut fokussierbare Laserstrahlen erzeugt werden. Da die Leistung der konventionellen Laser aber ohnehin als ausreichend zu betrachten ist, ist es beispielsweise interessanter mit diesem Verfahren die aufwendige Kühlung von Festkörperlasern ersetzten. Der bei diesen Lasertypen notwendige Kühlwasseranschluss, samt Kühlgerät und Dichtigkeitsproblemen lässt die Verwendung von mehreren in der vorher beschriebenen Art betriebenen Laserquellen vorteilhaft erscheinen, wenn nämlich die Parameter so gewählt werden, dass jeder einzelne Laser in der Pause zwischen zwei Pulsen nur durch Wärmeleitung auskühlen kann und daher eine Kühlwasserzufuhr eingespart wird.

In ähnlicher Weise ist Zeitmultiplexing bei konventionellen Diodenlasern zur Einsparung der Kühlwasserzufuhr (nicht zur Brillianzsteigerung) einsetzbar. Gerade bei Diodenlasern ist die Zufuhr des Kühlwassers durch aufwendige Mikrokanäle notwendig und die Abstände zwischen den Laserdioden müssen zu Kühlzwecken auch relativ groß gewählt werden, was dann durch aufwendige Optiken wieder korrigiert werden muss. Man aktiviert also eine Gruppe dicht gepackter Laserdioden solange, bis eine gewisse Überhitzung erreicht ist, aktiviert dann eine weitere Laserdiodengruppe (auch Laserdiodenstack genannt) und leitet mit einem optischen Multiplexer die Strahlen auf einen Pfad. Aufgrund des im Pulsbetrieb sehr klein wählbaren Abstandes zwischen den Laserdioden können aber hier Brillianzsteigerungen erzielt werden, auch ohne dass die Laserdioden mit signifikanter Pulsüberhöhung arbeiten.

## Patentansprüche

1. Verfahren zur Schaffung eines Laserstrahles hoher Brillanz unter Verwendung von $2^{n+1}$ Laserquellen (1, 2, ... 16), wobei n eine ganze, positive Zahl darstellt, bei dem die Laserquellen in gepulstem Modus betrieben werden und die erzeugten Laserpulse in einem optischen Multiplexer auf einen gemeinsamen optischen Pfad (OP) gelenkt werden, wobei der optische Multiplexer aus einer Kaskade im Strahlengang aufeinanderfolgender, in n + 1 Stufen angeordneter, polarisationsselektiver optischer Elemente (PS4, PS3, ... PS1) und jeweils zwischen diesen Stufen angeordneter, schaltbarer Polarisationsdreherstufen (PD3, PD2, PD1) besteht, wobei entweder in jeder Polarisationsdreherstufe für jeden Pfad ein schaltbarer Polarisationsdreher vorgesehen ist oder die Zahl der Polarisationsdreher in einer Polarisationsdreherstufe geringer ist als die Pfadanzahl und somit optische Pfade gemeinsam durch Polarisationsdreher geleitet werden oder jede Polarisationsdreherstufe aus einem einzigen alle Pfade umfassenden schaltbaren Polarisationsdreher besteht **dadurch gekennzeichnet, dass** jeweils zwei Laserquellen mit unterschiedlicher Polarisierung (V, H) gleichzeitig aktiviert werden.

2. Verfahren nach Anspruch 1, **dadurch gekennzeichnet, dass** jeweils zwei optische Ausgänge in einem Polarisationsfilter vereint werden.

3. Verfahren nach Anspruch 1 oder 2, **dadurch gekennzeichnet, dass** die Schaltzustände des optischen Multiplexers und die korrespondierenden Laserquellen zeitgleich mittels eines gemeinsamen Treibers durchgeschaltet werden.

4. Verfahren nach Anspruch 1, **dadurch gekennzeichnet, dass** der optische Multiplexer aus einer Kaskade von 2 x 1-Schaltern besteht.

5. Verfahren nach Anspruch 4, **dadurch gekennzeichnet, dass** die 2x1-Schalter aus der Gruppe bestehend aus elektrooptisch aktivierbarem Bragg-Schalter und elektro- oder magnetooptisch aktivierbaren Polarisationsdreher kombiniert mit darauffolgendem Polarisationsfilter gewählt werden.

6. Verfahren nach Anspruch 4, **dadurch gekennzeichnet, dass** 2 x 1-Schalter einer Kaskadierungsstufe zusammengefasst werden, so dass mehrere optische Pfade bis zu ihrer Vereinigung gemeinsam durch 2 x 1 Schalter geführt werden.

7. Verfahren nach einem der Ansprüche 1 bis 6, **dadurch gekennzeichnet, dass** die optischen Schalter einer Stufe mit einer vorgegebenen Frequenz f und die optischen Schalter der weiteren Stufen mit konstanter Phase und ganzzahligen Bruchteilen i der Frequenz f/i, i = 1, 2, 3, ..., aktiviert bzw. deaktiviert werden, so dass alle möglichen Schaltzustände periodisch geschaltet werden.

8. Verfahren nach einem der Ansprüche 1 bis 7, **dadurch gekennzeichnet, dass** die schaltbaren Polarisationsdreher jeder Stufe durch Pockelszellen realisiert sind und die Spannungsverläufe an den Pockelszellen harmonisch sind und mit elektrischen Schwingkreisen erzeugt werden.

9. Verfahren nach einem der Ansprüche 1 bis 7, **dadurch gekennzeichnet, dass** die schaltbaren Polarisationsdreher jeder Stufe mit Pockelszellen und Faradayrotatoren realisiert sind, so dass mit letzteren elektrische Schwingkreise realisiert werden, welche die nötigen Spannungs- und Stromverläufe generieren.

10. Verfahren nach einem der Ansprüche 1 bis 9 für drei Kaskadierungsstufen, **dadurch gekennzeichnet, dass** eine Kaskadierungsstufe mit einer vorgegebenen Frequenz f eine zweite Stufe 90° phasenverschoben mit der Frequenz f und die dritte Stufe 45° phasenverschoben mit der doppelten Frequenz 2f aktiviert bzw. deaktiviert wird und dass die Laserquellen (1, 2, ... 16) phasenrichtig mit einer Frequenz aktiviert werden.

## Claims

1. Method for providing a laser beam of high brilliance using $2^{n+1}$ laser sources (1, 2, ... 16), wherein n represent a whole, positive number, in which method the laser sources are operated in pulsed mode and the laser pulses produced are directed, in an optical multiplexer, onto a common optical path (OP), wherein the optical multiplexer consists of a cascade of polarisation-selective optical elements (PS4, PS3, ... PS1) arranged in the beam path in succession in n + 1 stages and of switchable polarisation rotator stages (PD3, PD2, PD1) each arranged between those stages, wherein either a switchable polarisation rotator is provided for each path in each polarisation rotator stage or the number of polarisation rotators in a polarisation rotator stage is less than the number of paths and therefore optical paths are passed together through polarisation rotators or each polarisation rotator stage consists of a single switchable polarisation rotator that includes all the paths, **characterised in that** in each case two laser sources with different polarisation (V, H) are activated simultaneously.

2. Method according to claim 1, **characterised in that** in each case two optical outputs are combined in a polarisation filter.

3. Method according to claim 1 or 2, **characterised in that** the switching states of the optical multiplexer and the corresponding laser sources are switched through simultaneously by means of a common driver.

4. Method according to claim 1, **characterised in that** the optical multiplexer consists of a cascade of 2 x 1 switches.

5. Method according to claim 4, **characterised in that** the 2 x 1 switches are selected from the group consisting of electro-optically activatable Bragg switches and electro- or magneto-optically activatable polarisation rotators combined with subsequent polarisation filters.

6. Method according to claim 4, **characterised in that** 2 x 1 switches of a cascading stage are combined, so that a plurality of optical paths are passed together through 2 x 1 switches before being combined.

7. Method according to any one of claims 1 to 6, **characterised in that** the optical switches of one stage are activated and deactivated with a predefined frequency f and the optical switches of the further stages are activated and deactivated with constant phase and integral fractions i of the frequency f/i, i = 1, 2, 3, ..., so that all possible switching states are switched periodically.

8. Method according to any one of claims 1 to 7, **characterised in that** the switchable polarisation rotators of each stage are implemented by Pockels cells and the voltage characteristics at the Pockels cells are harmonic and are produced by electrical oscillating circuits.

9. Method according to any one of claims 1 to 7, **characterised in that** the switchable polarisation rotators of each stage are implemented with Pockels cells and Faraday rotators, so that, with the latter, electrical oscillating circuits that generate the necessary voltage and current characteristics are implemented.

10. Method according to any one of claims 1 to 9 for three cascading stages, **characterised in that** one cascading stage is activated and deactivated with a predefined frequency f, a second stage is activated and deactivated phase-shifted by 90° with the frequency f, and the third stage is activated and deactivated phase-shifted by 45° with twice the frequency 2f, and the laser sources (1, 2, ... 16) are activated in correct phase relation with a frequency f.

## Revendications

1. Procédé pour créer un faisceau laser de brillance élevée en utilisant $2^{n+1}$ sources laser (1, 2, ... 16), n représentant un chiffre entier positif, dans lequel les sources laser sont exploitées en mode pulsé et les impulsions laser générées sont guidées dans un multiplexeur optique sur un chemin optique commun (OP), sachant que le multiplexeur optique est composé d'une cascade d'éléments optiques (PS4, PS3, ... PS1) à polarisation sélective, disposés en n +1 étages, se succédant dans le trajet des rayons, et d'étages de rotateurs de polarisation (PD3, PD2, PD1) commutables, disposés chaque fois entre ces étages, sachant que soit il est prévu dans chaque étage de rotateur de polarisation un étage de rotateur de polarisation commutable pour chaque chemin, soit le nombre de rotateurs de polarisation dans un étage de rotateurs de polarisation est plus petit que le nombre de chemins et par conséquent des chemins optiques sont guidés en commun par des rotateurs de polarisation, soit chaque étage de rotateurs de polarisation est composé d'un seul rotateur de polarisation commutable comprenant tous les chemins, **caractérisé en ce que** deux sources laser de polarisation différente (V, H) sont chaque fois activées en même temps.

2. Procédé selon la revendication 1, **caractérisé en ce que** deux sorties optiques sont chaque fois réunies dans un filtre de polarisation.

3. Procédé selon la revendication 1 ou 2, **caractérisé en ce que** les états de commutation du multiplexeur optique et les sources laser correspondantes sont transmis simultanément au moyen d'un circuit d'attaque commun.

4. Procédé selon la revendication 1, **caractérisé en ce que** le multiplexeur optique est composé d'une cascade de commutateurs 2 x 1.

5. Procédé selon la revendication 4, **caractérisé en ce que** les commutateurs 2 x 1 sont choisis parmi le groupe composé de commutateurs de Bragg à activation électro-optique et de rotateurs de polarisation à activation électro- ou magnéto-optique combinés avec des filtres de polarisation suivants.

6. Procédé selon la revendication 4, **caractérisé en ce que** des commutateurs 2 x 1 d'un étage de mise en cascade sont regroupés de façon que plusieurs chemins optiques soient guidés en commun par des commutateurs 2 x 1 jusqu'à leur réunion.

7. Procédé selon l'une des revendications 1 à 6, **caractérisé en ce que** les commutateurs optiques d'un étage sont activés ou désactivés à une fréquence f donnée et les commutateurs optiques des autres étages à phase constante et à des fractions entières i de la fréquence f/i, i = 1, 2, 3, ..., de façon que tous les états de commutation possibles soient périodiquement activés.

8. Procédé selon l'une des revendications 1 à 7, **caractérisé en ce que** les rotateurs de polarisation commutables de chaque étage sont réalisés par des cellules de Pockel et les courbes de tension aux cellules de Pockel sont harmoniques et générées avec des circuits résonants électriques.

9. Procédé selon l'une des revendications 1 à 7, **caractérisé en ce que** les rotateurs de polarisation commutables de chaque étage sont réalisés par des cellules de Pockel et des rotateurs de Faraday de façon que soient réalisés avec ces derniers des circuits résonants électriques qui génèrent les courbes de tension et de courant nécessaires.

10. Procédé selon l'une des revendications 1 à 9 pour trois étages de mise en cascade, **caractérisé en ce qu'**un étage de mise en cascade est activé ou désactivé à une fréquence f donnée, un deuxième étage avec un déphasage de 90° à la fréquence f et le troisième étage avec un déphasage de 45° à la fréquence double 2f, et que les sources laser (1, 2, ... 16) sont activées en phase à une fréquence f.

**Fig. 1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5250810 A
- US 2002000426 A1
- DE 19643489 C1
- DE 4326196 A1
- DE 10102723 A1

### In der Beschreibung aufgeführte Nicht-Patentliteratur

- **M.BARTRAM.** Pulse widths less than 100ns at 500A Current: Challenge to Explore New Applications with High-Power Laser Diode Arrays. *Proceedings of the Second International WLT-Conference on Lasers in Manufacturing 2003,* Juni 2003
- **F.AGULLO-LOPEZ et al.** Electrooptics. Academic Press, 1994
- **J.EICHLER.** Laser. Springer-Verlag, 2002
- **M.BASS et al.** Handbook of Optics. Mc Graw Hill, 1995, vol. II